# DEMANDE DE BREVET EUROPEEN

(11) **EP 1 241 704 A1**
(43) Date de publication de la demande: **18.09.2002**
(21) Numéro de dépôt: 02290545.9
(22) Date de dépôt: 06.03.2002
(51) Int. Cl.: H01L 21/331, H01L 29/737

(54) **Procédé de fabrication d'un transistor bipolaire de type double polysilicum à base à hétérojonction et transistor correspondant**

(30) Priorité: 14.03.2001 FR 0103469
(71) Demandeur: STMicroelectronics S.A., 92120 Montrouge (FR)
(72) Inventeur: Chantre, Alain, 38180 Seyssins (FR); Baudry, Hélène, 38100 Grenoble (FR); Dutartre, Didier, 38240 Meylan (FR)
(74) Mandataire: Casalonga, Axel

(57) **Abrégé**

Transistor et procédé de fabrication d'un transistor bipolaire du type double-polysilicium à base à hétérojonction, dans lequel on forme par épitaxie non sélective, une couche semi-conductrice à hétérojonction SiGe 2 sur une région active ZA d'un substrat SB et une région isolante STI entourant ladite région active ZA, on forme sur la couche semi-conductrice 2 au-dessus d'une partie de ladite région active, au moins une couche d'arrêt 3, on forme sur la couche semi-conductrice 2 et sur une partie de la couche d'arrêt 3 une couche de polysilicium 5 et une couche isolante supérieure 6 en laissant libre une fenêtre d'émetteur 7, et on forme par épitaxie une région d'émetteur 9 dans ladite fenêtre d'émetteur 7, reposant partiellement sur la couche isolante supérieure 6 et en contact avec la couche semi-conductrice 2.

## Description

L'invention concerne les composants semiconducteurs, notamment ceux destinés à s'intégrer dans les technologies haute fréquence et à très haut degré d'intégration (Technologie VLSI : "Very Large Scale Integration" en langue anglaise) et notamment les transistors bipolaires du type double-polysilicium auto-aligné à base à hétérojonction silicium-germanium, en particulier ceux ayant une base épitaxiée, et leur procédé de fabrication.

D'une manière générale, un transistor du type double-polysilicium est un transistor dont l'émetteur et la base extrinsèque sont en silicium polycristallin (polysilicium) par opposition à un transistor bipolaire simple polysilicium dont seul l'émetteur est en polysicilium.

Par ailleurs, un transistor double-polysilicium est dit "auto-aligné" lorsque la distance entre le polysilicium de la base extrinsèque et le polysilicium de l'émetteur n'est définie par aucune opération de photolithographie, c'est-à-dire notamment par aucun ajustement de deux masques de photolithographie l'un par rapport à l'autre.

Dans un procédé classique de fabrication d'un transistor bipolaire double-polysilicium auto-aligné, dont la base intrinsèque est implantée, on dépose sur une zone active d'un substrat semiconducteur ayant un type de conductivité donné (par exemple le type N) un empilement de couches comportant une couche de polysilicium fortement dopée avec un type de conductivité opposé à celui du substrat (par exemple dopé P+) surmontée d'une couche isolante supérieure, par exemple en dioxyde de silicium. La couche de polysilicium P+ est destinée à former ultérieurement la base extrinsèque du transistor. On grave ensuite l'empilement au-dessus de la zone active de façon à définir une fenêtre d'émetteur. On réalise des régions d'isolement électriques ou "espaceurs" sur les flancs de la fenêtre d'émetteur et l'on dépose du polysilicium dans la fenêtre d'émetteur de façon à former la région d'émetteur. Cette région d'émetteur est ainsi isolée de la base extrinsèque par les espaceurs internes et également par une partie de la région isolante supérieure de l'empilement sur laquelle cette région d'émetteur repose partiellement.

Durant l'opération de gravure de l'empilement, il se produit une surgravure qui a pour effet de retirer une partie du silicium de la zone active. Le contrôle et la reproductibilité de cette surgravure sont suffisants dans le contexte d'un transistor à base implantée, dans lequel l'implantation de la base intrinsèque est généralement effectuée après l'ouverture de la fenêtre d'émetteur.

La situation est différente dans un transistor à base épitaxiée, en particulier si l'on souhaite disposer d'une base intrinsèque à hétérojonction silicium-germanium. En effet, dans les transistors à base épitaxiée, on utilise généralement une épitaxie non sélective pour déposer sur la zone active et sur les régions isolantes délimitant cette zone active, une région semiconductrice au sein de laquelle sera réalisée la future base intrinsèque. On dépose alors l'empilement de couches évoqué plus haut sur cette première région semiconductrice. Or, l'épaisseur de la première région semiconductrice, c'est-à-dire l'épaisseur de la base intrinsèque, est particulièrement faible, typiquement quelques dizaines de nanomètres. Et cette base intrinsèque déjà particulièrement fine à l'origine, est inévitablement partiellement gravée lors de la surgravure résultant de la gravure de l'empilement pour la définition de la fenêtre d'émetteur. Ceci peut conduire à des dégradations du fonctionnement électrique du transistor, voire à un transistor défectueux.

Une solution consiste à n'effectuer la croissance épitaxiale de la base intrinsèque qu'une fois que la fenêtre d'émetteur a été gravée. Cependant, une telle solution nécessite l'utilisation d'une épitaxie sélective, ce qui pose d'autres problèmes technologiques plus délicats que pour une épitaxie non sélective, tels qu'un contrôle plus délicat de l'épaisseur de la base, ainsi que des difficultés plus importantes pour l'obtention d'une bonne qualité de la base épitaxiée.

L'invention vise à apporter une solution à ce problème.

Un but de l'invention est de réaliser un transistor du type double-polysilicium à base à hétérojonction, qui utilise une épitaxie non sélective de la base tout en restant simple à fabriquer et avec de bonnes performances.

Le procédé de fabrication d'un transistor bipolaire du type double-polysilicium à base à hétérojonction, selon un aspect de l'invention, comprend les étapes suivantes :
- on forme par épitaxie non sélective, une couche semi-conductrice à hétérojonction silicium-germanium sur une région active d'un substrat semi-conducteur et une région isolante entourant ladite région active,
- on forme sur la couche semi-conductrice à hétérojonction au-dessus d'une partie de ladite région active, au moins une couche d'arrêt de gravure,
- on forme sur la couche semi-conductrice à hétérojonction et sur une partie de ladite couche d'arrêt une couche de polysilicium et une couche isolante supérieure de façon qu'une fenêtre d'émetteur soit laissée libre, et
- on forme par épitaxie une région d'émetteur dans ladite fenêtre d'émetteur, reposant partiellement sur ladite couche isolante supérieure et en contact avec la couche semi-conductrice à hétérojonction.

Avantageusement on forme des espaceurs dans la fenêtre d'émetteur.

Au préalable, la région active du substrat peut être préparée par implantation ionique pour former des couches enterrées de type n+ et p+, un collecteur épitaxié de type n, et la région isolante est formée.

Dans un mode de réalisation de l'invention, on peut, au préalable, former une couche isolante inférieure recouvrant la région active et la région isolante entourant ladite région active, et graver la couche isolante pour définir une ouverture au-dessus de la région active et d'une partie de la région isolante entourant ladite région active. La couche isolante peut comprendre de l'oxyde de silicium, de l'oxynitrure de silicium et/ou du silicium amorphe.

Dans un mode de réalisation de l'invention, la couche semi-conductrice à hétérojonction silicium-germanium est formée dans ladite ouverture directement sur la région active.

Dans un mode de réalisation de l'invention, on forme une couche d'arrêt inférieure et une couche d'arrêt supérieure de compositions telles qu'elles puissent être gravées sélectivement. La couche d'arrêt inférieure peut comprendre de l'oxyde de silicium et la couche d'arrêt supérieure peut comprendre du nitrure de silicium. Lesdites couches d'arrêt peuvent être formées par dépôt puis gravure. On peut ensuite nettoyer la surface supérieure de la couche semi-conductrice à hétérojonction pour en retirer d'éventuelles traces d'oxyde, par exemple avec de l'acide fluorhydrique.

Dans un mode de réalisation de l'invention, la couche de polysilicium est déposée de façon non sélective, puis est dopée pour lui conférer une conductivité de type p+, puis la couche isolante supérieure est déposée de façon non sélective, puis la couche isolante supérieure et la couche de polysilicium sont gravées sélectivement au-dessus d'une partie de la couche d'arrêt de gravure, la gravure étant arrêtée sensiblement sur ladite couche d'arrêt de gravure. La couche de polysilicium peut être dopée avec du bore. La couche isolante supérieure peut comprendre de l'oxyde de silicium. La gravure sera avantageusement anisotrope. On peut ensuite doper une partie de la région active par une espèce de type N telle que du phosphore ou de l'arsenic qui traversera la ou les couches d'arrêt de gravure.

Les espaceurs peuvent être formés par dépôt dans ladite fenêtre d'émetteur d'un matériau isolant, puis par gravure en laissant subsister ledit matériau isolant sur les bords de la fenêtre. De préférence, ledit matériau isolant est identique au matériau formant la couche d'arrêt supérieure. La gravure pourra retirer la couche d'arrêt supérieure située dans le fond et au centre de la fenêtre d'émetteur. On peut utiliser une gravure sèche.

Dans un mode de réalisation de l'invention, préalablement à l'étape de formation de la région d'émetteur, on grave la couche d'arrêt inférieure située dans le fond et au centre de la fenêtre d'émetteur sélectivement par rapport à la couche semi-conductrice à hétérojonction pour dégager ladite couche semi-conductrice à hétérojonction.

Dans un mode de réalisation de l'invention, on dépose une couche de polysilicium dopé pour former une région d'émetteur.

Dans un mode de réalisation de l'invention, on dépose la couche de polysilicium de façon non sélective puis on grave ladite couche de polysilicium et la couche isolante supérieure de façon anisotrope.

Avantageusement, la couche de polysilicium est de conductivité de type n+. Dans un mode de réalisation de l'invention, on dope la couche de polysilicium avec de l'arsenic.

Postérieurement à l'étape de formation de la région d'émetteur, on peut retirer par gravure la couche de polysilicium et la couche semi-conductrice à hétérojonction en dehors de la région active et d'une partie de la région isolante entourant ladite région active. On peut retirer la couche isolante inférieure également en dehors de la région active et d'une partie de la région isolante entourant ladite région active.

On peut effectuer un recuit pour activer les espèces implantées. On peut former des espaceurs sur les bords de la couche de polysilicium et la couche semi-conductrice à hétérojonction et sur les bords de la couche isolante inférieure, par exemple par dépôt d'une couche isolante supplémentaire et gravure isotrope. On peut déposer une couche métallique, par exemple comprenant du titane, en surface de la couche de polysilicium et de la région d'émetteur pour assurer un contact électrique de haute qualité.

L'invention propose également un transistor bipolaire du type double-polysilicium à base à hétérojonction, comprenant une région active d'un substrat semi-conducteur et une région isolante entourant ladite région active, une couche semi-conductrice à hétérojonction silicium-germanium épitaxiée disposée sur la région active et une partie de la région isolante, au moins une couche d'arrêt de gravure disposée sur la couche semi-conductrice à hétérojonction au-dessus d'une partie de ladite région active, une couche de polysilicium disposée sur la couche semi-conductrice à hétérojonction et sur une partie de ladite couche d'arrêt et une couche isolante supérieure sur une partie de ladite couche de polysilicium, ladite couche isolante supérieure et ladite couche de polysilicium laissant libre une fenêtre d'émetteur, des espaceurs disposés dans la fenêtre d'émetteur, et une région d'émetteur épitaxiée disposée dans ladite fenêtre d'émetteur, reposant partiellement sur ladite couche isolante supérieure et en contact avec la couche semi-conductrice à hétérojonction.

La région active du substrat peut comprendre des couches enterrées de type n+ et p+, un collecteur épitaxié de type n, et la région isolante peut être formée par le procédé de tranchées peu profondes, dit STI (Shallow Trench Isolation en langue anglaise).

Dans un mode de réalisation de l'invention, le transistor comprend une couche isolante inférieure recouvrant en partie la région isolante entourant ladite région active tout en étant pourvue d'une ouverture au-dessus de la région active et d'une partie de la région isolante.

La couche isolante peut comprendre de l'oxyde de silicium, de l'oxynitrure de silicium et/ou du silicium amorphe.

De préférence, la couche semi-conductrice à hétérojonction silicium-germanium est en contact direct avec la région active.

Dans un mode de réalisation de l'invention, le transistor comprend une couche d'arrêt inférieure et une couche d'arrêt supérieure de compositions telles que lesdites couches d'arrêt puissent être gravées sélectivement.

La couche d'arrêt inférieure peut comprendre de l'oxyde de silicium et la couche d'arrêt supérieure peut comprendre du nitrure de silicium. Lesdites couches d'arrêt peuvent être formées par dépôt puis gravure. On peut ensuite nettoyer la surface supérieure de la couche semi-conductrice à hétérojonction pour en retirer d'éventuelles traces d'oxyde, par exemple avec de l'acide fluorhydrique.

La couche de polysilicium comprend une espèce dopante pour lui conférer une conductivité de type p+. La couche de polysilicium peut être dopée avec du bore. La couche isolante supérieure peut comprendre de l'oxyde de silicium.

Dans un mode de réalisation de l'invention, les espaceurs comprennent le même matériau que la couche d'arrêt supérieure.

Dans un mode de réalisation de l'invention, la région d'émetteur comprend une espèce dopante de conductivité de type n+. Dans un mode de réalisation de l'invention, la couche de polysilicium est dopée avec de l'arsenic.

D'autres avantages et caractéristiques de l'invention apparaîtront à l'examen de la description détaillée de modes de mise en oeuvre et de réalisation, nullement limitatifs, sur lesquels :

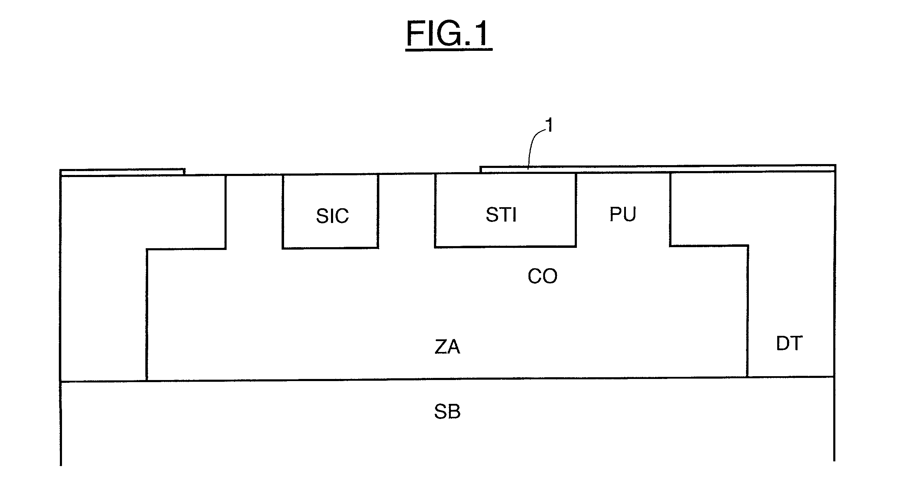

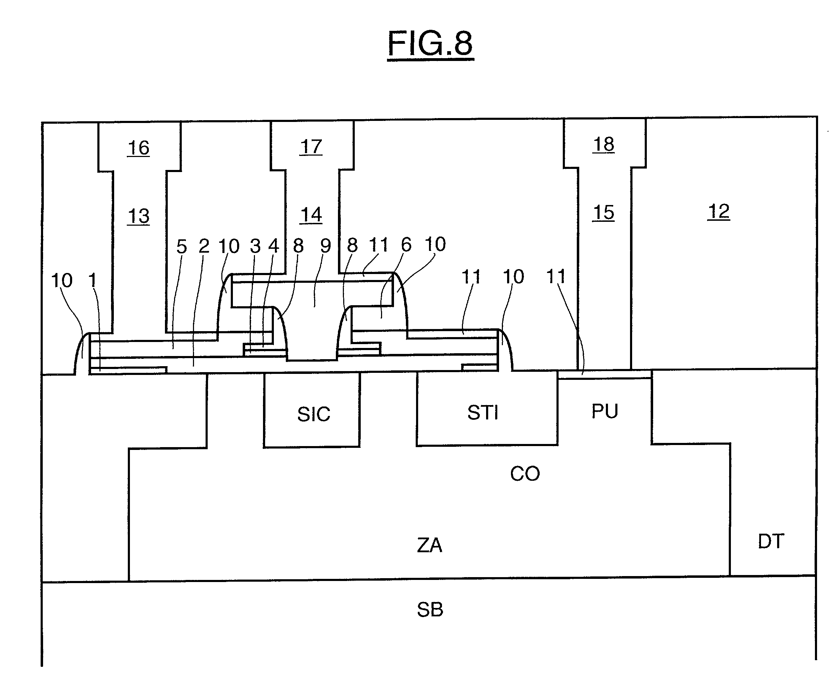

- les figures 1 à 8 illustrent très schématiquement les principales étapes d'un procédé de fabrication d'un transistor selon l'invention, la figure 8 illustrant par ailleurs également très schématiquement un mode de réalisation d'un transistor selon l'invention.

Sur la figure 1, la référence SB désigne un substrat semiconducteur, par exemple en silicium, ayant dans le cas présent un type de conductivité N. On délimite, de façon classique et connue en soi, une zone active ZA au sein de ce substrat SB en réalisant de part et d'autre de cette zone ZA des régions isolantes STI, par exemple par un procédé connu de l'homme du métier sous la dénomination de "Shallow Trench Isolation" ("isolation par tranchées peu profondes"). Cette zone active va former le collecteur intrinsèque du transistor.

De façon connue en soi, la zone active ZA comprend des couches enterrées de type N⁺ et P⁺, un collecteur CO épitaxié de type N pourvu d'un puits de contact PU. La zone active est isolée de zones actives voisines, non représentées, par des zones isolantes profondes DT, obtenues par exemple par un procédé connu de l'homme du métier sous la dénomination de « Deep Trench Isolation » (« Isolation par tranchées profondes »). Les régions isolantes STI pourraient également être formées par le procédé connu sous le nom de LOCOS. Enfin, une partie SIC de la zone active ZA fait l'objet d'un surdopage localisé. Le surdopage localisé peut être réalisé en partie à cette étape puis être affiné plus tard, confer infra. La partie SIC est prévue à l'endroit où sera formé l'émetteur.

On dépose ensuite une couche isolante inférieure 1 de façon non sélective. La couche isolante inférieure 1 peut comprendre de l'oxyde de silicium ou du silicium amorphe ou encore, et de préférence, une bicouche formée d'une partie inférieure en oxyde de silicium et d'une partie supérieure en silicium amorphe. On grave ladite couche isolante inférieure 1 pour former une ouverture au-dessus de la région active ZA, notamment de la partie SIC et, avantageusement, d'une partie de la région isolante STI au voisinage de la région active ZA.

On fait croître ensuite par épitaxie non sélective, une région semiconductrice à hétérojonction 2. L'épitaxie non sélective se caractérise par une croissance de cette région semiconductrice non seulement sur la zone active ZA, mais aussi sur les régions isolantes STI et sur la couche isolante 1.

La région semiconductrice à hétérojonction silicium-germanium 2, qui a typiquement une épaisseur de quelques dizaines de nanomètres, par exemple entre 50 et 80 nm, est en fait constituée de plusieurs couches superposées. Ainsi, on procède à une épitaxie non sélective d'une première couche de silicium non dopée. On épitaxie ensuite une deuxième couche formée de silicium-germanium, cette deuxième couche étant composée, par exemple, d'une première sous-couche de Si₁₋ₓGeₓ avec x constant compris entre 0,1 et 0,2 surmontée d'une deuxième sous-couche formée également d'un alliage de Si₁₋ₓGeₓ (avec x par exemple décroissant jusqu'à 0) et dopée P par du bore. La deuxième couche est ensuite surmontée d'une couche épitaxiée de silicium dopée P par du bore.

A l'issue de cette épitaxie, réalisée typiquement à 700° dans un réacteur de dépôt CVD ultrapropre, on obtient un empilement de couches permettant de former une base intrinsèque à hétérojonction silicium-germanium. On comprendra, qu'au-dessus de la zone active ZA, la couche 2 présente une forme monocristalline, tandis qu'en-dehors de la zone active ZA, c'est-à-dire au-dessus des régions isolantes STI et de la couche isolante inférieure 1, la couche 2 présente une forme polycristalline due à l'absence de monocristal de silicium au début de l'épitaxie.

On dépose ensuite de façon non sélective une couche inférieure 3 d'arrêt de gravure puis une couche supérieure 4 d'arrêt de gravure. La couche inférieure 3 peut comprendre de l'oxyde de silicium, tandis que la couche supérieure 4 peut comprendre du nitrure de silicium. Alternativement, la couche inférieure 3 peut comprendre de l'oxynitrure de silicium, tandis que la couche supérieure 4 comprend du nitrure de silicium. Alternativement, la couche inférieure 3 peut comprendre de l'oxyde de silicium, tandis que la couche supérieure 4 comprend de l'oxynitrure de silicium. D'autres combinaisons peuvent également être envisagées, la couche supérieure 4 pouvant être gravée sélectivement par rapport à la couche inférieure 3, et la couche inférieure 3 par rapport à la couche semiconductrice 2.

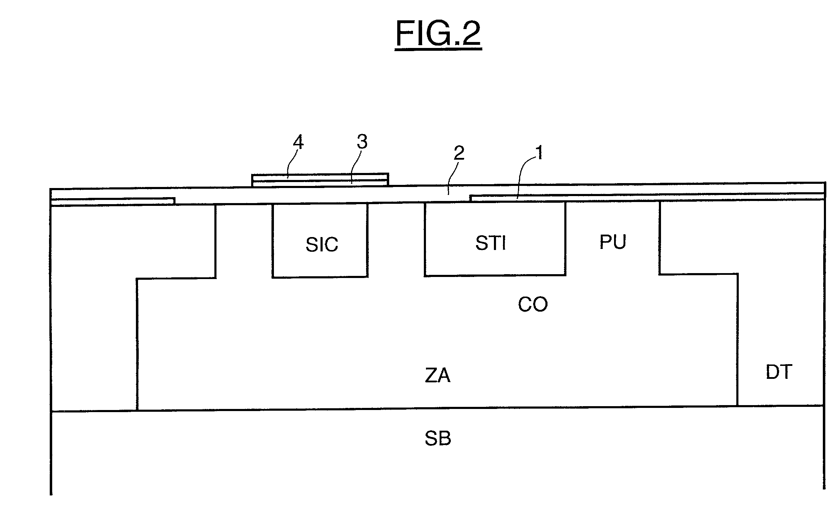

On procède ensuite à une étape de lithogravure, par exemple avec une gravure sèche par plasma pour ôter la couche supérieure 4 sélectivement par rapport à la couche inférieure 3. On laisse subsister la couche supérieure 4 au-dessus de la partie surdopée SIC de la zone active ainsi qu'au-dessus d'une partie de la zone active voisine de la partie surdopée SIC. On procède ensuite au retrait de la résine ayant servi à la lithogravure, puis on effectue une gravure, par exemple de type chimique, pour ôter la couche inférieure 3 sélectivement par rapport à la couche semiconductrice 2. Ladite gravure laisse subsister la couche inférieure 3 aux mêmes endroits que la couche supérieure 4, voir figure 2.

On procède ensuite à une étape de nettoyage de la surface supérieure de l'empilement pour en ôter d'éventuels restes d'oxyde de silicium et favoriser ainsi le contact électrique entre la couche semiconductrice 2 et la couche qui va être déposée ultérieurement. Le nettoyage peut être effectué à l'aide d'acide fluorhydrique HF.

On procède ensuite au dépôt non sélectif d'une couche 5 de polysilicium destinée à former la base extrinsèque du transistor bipolaire. La couche 5 de polysilicium est ensuite dopée P⁺, par exemple avec du bore, de façon telle que le dopant ne traverse pas la couche d'arrêt supérieure 4 et ce afin d'éviter un surdopage de la partie de la couche semiconductrice 2 située sous les couches d'arrêt 3 et 4. On dépose ensuite une couche isolante supérieure 6, de façon non sélective, par exemple en oxyde de silicium.

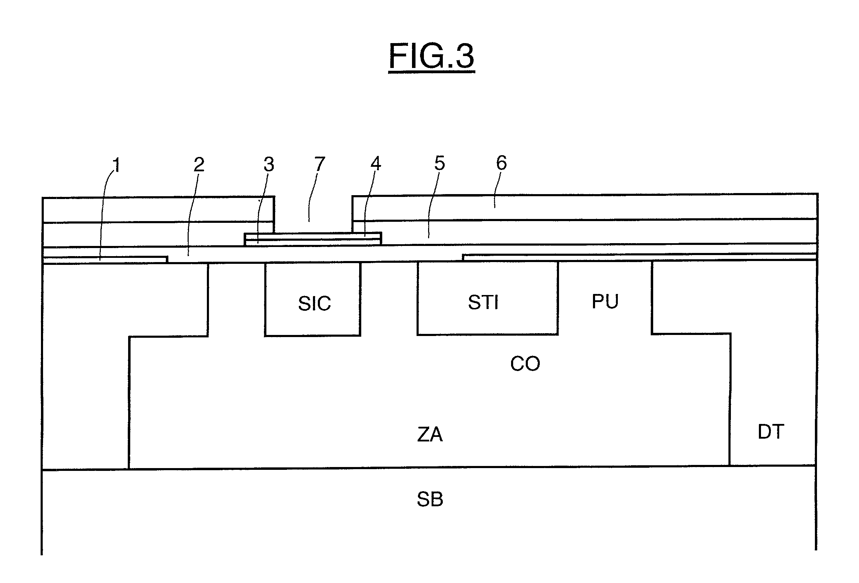

On grave ensuite la couche 6 puis la couche 5 pour ouvrir une fenêtre d'émetteur 7 au-dessus d'une partie de la couche d'arrêt supérieure 4 et de façon sensiblement alignée avec la partie surdopée SIC de la zone active ZA. La gravure peut être effectuée par une lithographie utilisant un masque et deux chimies différentes de gravure, l'une pour la couche isolante 6, et l'autre pour la couche de polysilicium 5. En d'autres termes, on grave d'abord la couche isolante 6 en s'arrêtant sur la couche de polysilicium 5, et ce tout en pouvant utiliser une chimie de gravure peu sélective par rapport à la couche de polysilicium 5. Puis on grave la couche de polysilicium 5 de façon sélective par rapport à la couche d'arrêt supérieure 4, voir figure 3.

A cette étape, si le surdopage de la partie SIC de la zone active ZA n'a pas encore été effectué ou si on souhaite contrôler avec précision le dopage du collecteur à la jonction base/collecteur, on peut prévoir une opération d'implantation d'espèce dopante apte à traverser la couche d'arrêt supérieure 4, la couche d'arrêt inférieure 3 et la couche semiconductrice 2 pour atteindre la zone active ZA.

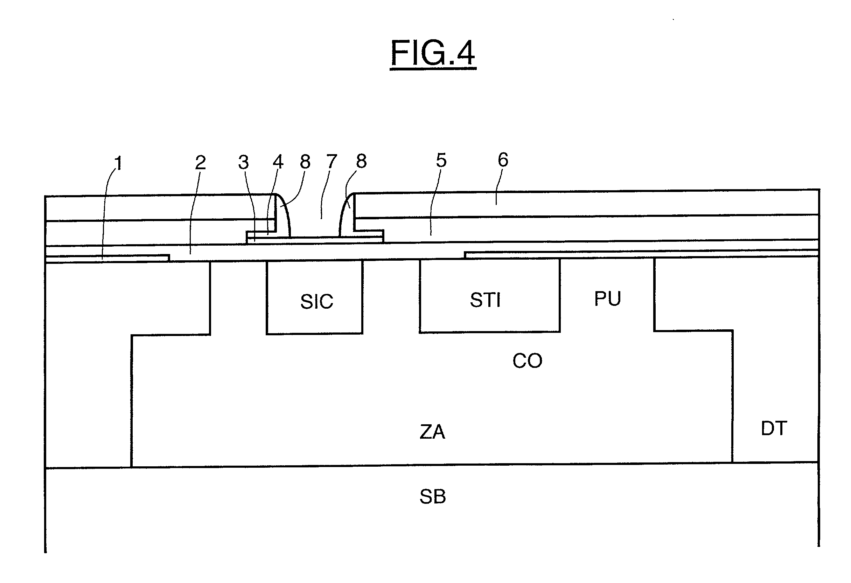

On remplit ensuite la fenêtre d'émetteur 7 d'un matériau identique à celui constituant la couche d'arrêt supérieure 4, par exemple en nitrure de silicium Si₃N₄. Le dépôt de ce matériau peut avoir lieu de façon non sélective sur l'ensemble de l'empilement. Puis on effectue une gravure dudit matériau de façon sélective par rapport à la couche isolante supérieure 6 et par rapport à la couche d'arrêt inférieure 3, par exemple une gravure anisotrope, notamment une gravure sèche de façon telle qu'elle laisse subsister des espaceurs 8 sur les bords de la fenêtre d'émetteur 7 tout en dégageant bien le fond de ladite fenêtre d'émetteur 7, voir figure 4.

On procède ensuite à une étape de gravure humide de la couche d'arrêt inférieure 3 située au fond de la fenêtre d'émetteur 7 pour atteindre la couche semiconductrice 2.

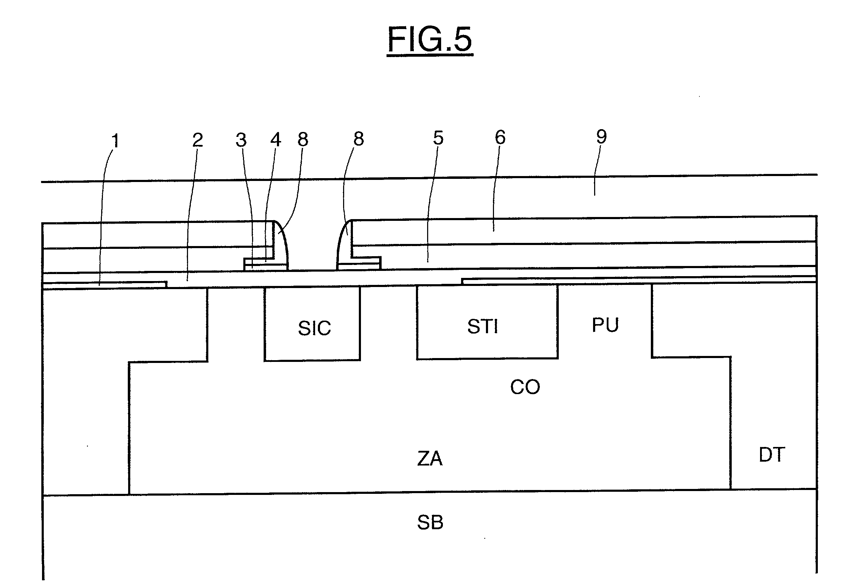

On dépose ensuite une couche de polysilicium 9 sur l'ensemble de l'empilement de façon telle qu'il remplisse la fenêtre d'émetteur 7, voir figure 5. Avantageusement, la couche de polysilicium 9 est dopée N⁺ lors de son dépôt. Le dopage lors du dépôt peut être effectué par introduction d'arsine dans le réacteur dans lequel est disposé l'empilement en même temps que l'introduction des gaz permettant la formation du polysilicium. On favorise ainsi une bonne répartition de l'arsenic dans la couche de polysilicium 9. En outre, le dépôt de la couche de polysilicium 9 dopée à l'arsenic peut avoir lieu après un traitement désoxydant par exemple un traitement thermique sous hydrogène, dans le même réacteur, ce qui garantit une excellente propreté et l'absence d'oxyde de silicium au fond de la fenêtre d'émetteur 7 lors dudit dépôt de la couche de silicium 9.

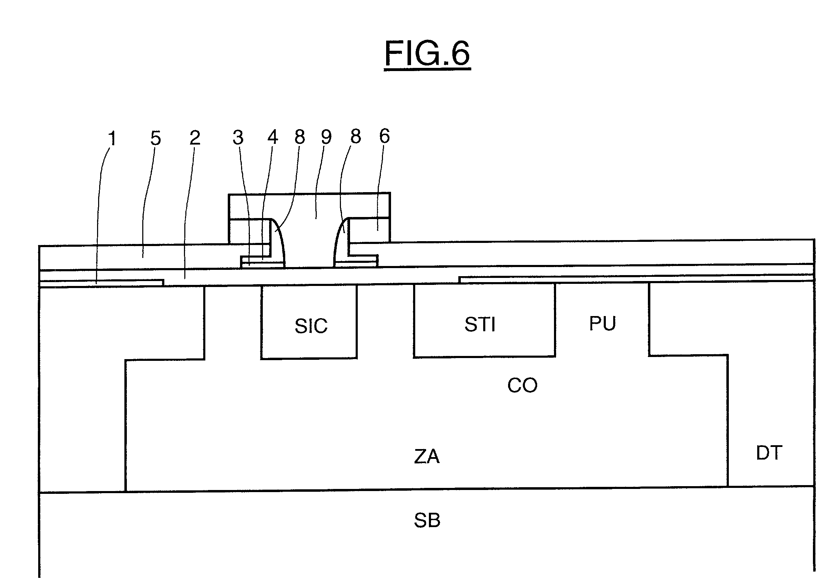

On procède ensuite à une double étape de gravure au moyen d'un seul masque et de deux chimies de gravure différentes, tout d'abord pour graver la couche de polysilicium 9 et l'ôter en-dehors de la fenêtre d'émetteur 7 et d'une zone voisine, puis pour ôter la couche isolante supérieure 6 aux mêmes endroits que la couche de polysilicium 9, voir figure 6. Cette double étape de gravure est donc économique et relativement rapide.

On procède ensuite à une étape de lithogravure de la couche de polysilicium 5, de façon qu'elle subsiste au-dessus de la zone active ZA et d'une zone voisine comprenant toute l'ouverture définie dans la couche isolante inférieure 1 et une partie de la couche isolante inférieure 1. Puis, on effectue une gravure de la couche semiconductrice 2 au même endroit que la couche de polysilicium 5 et enfin une gravure de la couche isolante inférieure 1 au même endroit que précédemment. La gravure est arrêtée sur les régions isolantes STI ainsi que sur le puits de collecteur PU.

De façon connue en soi, on peut alors procéder à l'activation des espèces implantées par recuit.

On procède ensuite à la formation d'espaceurs 10 sur les bords des portions subsistantes des couches isolante inférieure 1, semiconductrice 2 et de polysilicium 5 d'une part, et isolante supérieure 6 et de polysilicium 9, d'autre part. La formation des espaceurs 10 peut être effectuée par dépôt non sélectif d'une couche d'oxyde de silicium suivi d'une étape de gravure anisotrope.

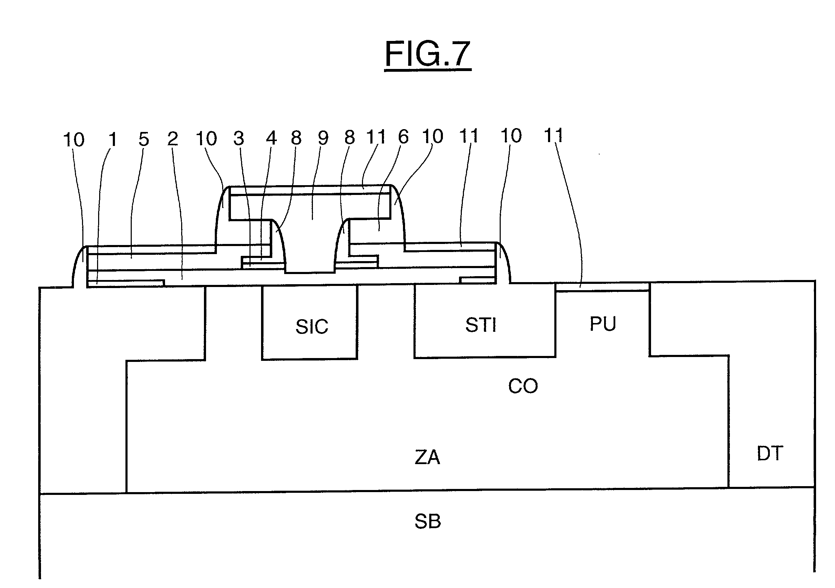

On procède ensuite à une étape de dépôt de titane puis à une étape de traitement thermique pour former une couche 11 de composé TiSi₂ aux endroits où le titane est en contact avec du silicium polycristallin, puis à une étape de retrait chimique sélectif du titane métal en conservant le composé TiSi₂, ce qui permet de favoriser les contacts électriques en surface du puits de collecteur PU de la couche de polysilicium 5 formant la base extrinsèque du transistor et de la couche de polysilicium 9 formant l'émetteur du transistor, voir figure 7.

On peut ensuite procéder au dépôt d'une épaisse couche diélectrique 12, de façon non sélective, puis à la formation de vias 13, 14 et 15 permettant d'atteindre respectivement la base extrinsèque du transistor, l'émetteur et le collecteur. Les vias 13, 14 et 15 peuvent ensuite être surmontés de plots de contact 16, 17 et 18 respectivement, voir figure 8.

Grâce à l'invention, on réalise un transistor bipolaire vertical à base épitaxiée non sélective Si/SiGe avec une structure émetteur/base quasi auto-alignée mais sans pâtir de la complexité de l'auto-alignement. L'émetteur épitaxié permet d'obtenir un transistor ayant d'excellentes performances, notamment un faible bruit 1/f, une faible résistance d'émetteur, une excellente reproductibilité de la fabrication et un excellent contrôle des caractéristiques lors de la fabrication.

Il est particulièrement avantageux d'épitaxier la couche 9 formant l'émetteur dans le réacteur dans lequel l'empilement a subi l'étape de traitement désoxydant notamment du fond de la fenêtre d'émetteur 7 permettant de supprimer localement la couche d'arrêt inférieure 3 et d'atteindre la couche semiconductrice 2. On évite ainsi toute entrée d'air et donc d'oxygène risquant de former des oxydes de silicium au fond de ladite fenêtre d'émetteur sur la surface dégagée de la couche semiconductrice 2.

Un transistor bipolaire ainsi fabriqué permet d'atteindre de très hautes performances avec une fréquence de transition f_{T} pouvant atteindre 70 GHz et une fréquence maximale pouvant atteindre 90 GHz. En outre, le procédé de fabrication est compatible avec les procédés BiCMOS. Et l'on bénéfice de la séquence unique de fabrication de l'émetteur et de la base grâce à l'épitaxie de l'émetteur avec une jonction émetteur/base très fine, de l'ordre de 15 nm, d'où une capacité émetteur/base réduite. La profondeur de jonction est reproductible aisément grâce à l'absence d'oxyde interfacial et au dopage in situ de la couche formant l'émetteur, d'où une excellente reproductibilité d'un lot de fabrication à un autre.

## Revendications

1. Procédé de fabrication d'un transistor bipolaire du type double-polysilicium à base à hétérojonction, dans lequel :
a) on forme par épitaxie non sélective, une couche semi-conductrice à hétérojonction silicium-germanium (2) sur une région active (ZA) d'un substrat semi-conducteur et une région isolante (STI) entourant ladite région active,
b) on forme sur la couche semi-conductrice à hétérojonction au-dessus d'une partie de ladite région active, au moins une couche d'arrêt de gravure (3),
c) on forme sur la couche semi-conductrice à hétérojonction et sur une partie de ladite couche d'arrêt une couche de polysilicium (5) et une couche isolante supérieure (6) de façon qu'une fenêtre d'émetteur (7) soit laissée libre, et
d) on forme par épitaxie une région d'émetteur (9) dans ladite fenêtre d'émetteur (7) reposant partiellement sur ladite couche isolante supérieure et en contact avec la couche semi-conductrice à hétéro-jonction.

2. Procédé selon la revendication 1, dans lequel, au préalable, on forme une couche isolante inférieure recouvrant la région active (ZA) et la région isolante (STI) entourant ladite région active, et l'on grave la couche isolante pour définir une ouverture au-dessus de la région active et d'une partie de la région isolante entourant ladite région active.

3. Procédé selon la revendication 2, dans lequel la couche semi-conductrice à hétérojonction silicium-germanium (2) est formée dans ladite ouverture directement sur la région active.

4. Procédé selon l'une quelconque des revendications précédentes, dans lequel à l'étape b) on forme une couche d'arrêt inférieure et une couche d'arrêt supérieure de compositions telles qu'elles puissent être gravées sélectivement.

5. Procédé selon l'une quelconque des revendications précédentes, dans lequel la couche de polysilicium est déposée de façon non sélective, puis est dopée pour lui conférer une conductivité de type p+, puis la couche isolante supérieure est déposée de façon non sélective, puis la couche isolante supérieure et la couche de polysilicium sont gravées sélectivement au-dessus d'une partie de la couche d'arrêt de gravure, la gravure étant arrêtée sensiblement sur ladite couche d'arrêt de gravure.

6. Procédé selon l'une quelconque des revendications précédentes, dans lequel préalablement à l'étape d), on grave la couche d'arrêt inférieure située dans le fond et au centre de la fenêtre d'émetteur sélectivement par rapport à la couche semi-conductrice à hétérojonction pour dégager ladite couche semi-conductrice à hétérojonction.

7. Procédé selon l'une quelconque des revendications précédentes, dans lequel à l'étape d), on dépose une couche de polysilicium dopé pour former une région d'émetteur.

8. Transistor bipolaire du type double-polysilicium à base à hétérojonction, **caractérisé par le fait qu'**il comprend une région active (ZA) d'un substrat semi-conducteur et une région isolante (STI) entourant ladite région active, une couche semi-conductrice à hétérojonction silicium-germanium (2) épitaxiée disposée sur la région active et une partie de la région isolante, au moins une couche d'arrêt de gravure (3) disposée sur la couche semi-conductrice à hétérojonction au-dessus d'une partie de ladite région active, une couche de polysilicium (5) disposée sur la couche semi-conductrice à hétérojonction et sur une partie de ladite couche d'arrêt et une couche isolante supérieure (6) sur une partie de ladite couche de polysilicium, ladite couche isolante supérieure et ladite couche de polysilicium laissant libre une fenêtre d'émetteur (7), et une région d'émetteur (9) épitaxiée disposée dans ladite fenêtre d'émetteur (7), reposant partiellement sur ladite couche isolante supérieure et en contact avec la couche semi-conductrice à hétérojonction.

9. Transistor selon la revendication 8, **caractérisé par le fait qu'**il comprend une couche isolante inférieure (1) recouvrant en partie la région isolante (STI) entourant ladite région active tout en étant pourvue d'une ouverture au-dessus de la région active et d'une partie de la région isolante.

10. Transistor selon la revendication 8 ou 9, **caractérisé par le fait qu'**il comprend une couche d'arrêt inférieure (3) et une couche d'arrêt supérieure (4) de compositions telles qu'elles puissent être gravées sélectivement.

11. Transistor selon la revendication 10, **caractérisé par le fait que** des espaceurs (8) disposés dans la fenêtre d'émetteur (7) comprennent le même matériau que la couche d'arrêt supérieure (4).

12. Transistor selon l'une quelconque des revendications 8 à 11, **caractérisé par le fait que** la région d'émetteur (9) comprend une espèce dopante de conductivité de type n+.
